# EUROPEAN PATENT APPLICATION

(11) **EP 2 711 993 A1**
(43) Date of publication of application: **26.03.2014**
(21) Application number: 13159358.4
(22) Date of filing: 15.03.2013
(51) Int. Cl.: H01L 33/50, H01L 33/48

(54) **Light emitting device and illumination apparatus**

(30) Priority: 25.09.2012 JP 2012211383; 06.03.2013 JP 2013044796
(71) Applicant: Toshiba Lighting & Technology Corporation, Yokosuka-shi Kanagawa 237-8510 (JP)
(72) Inventor: Oyaizu, Tsuyoshi, Kanagawa, 237-8510 (JP)
(74) Representative: Bokinge, Ole

(57) **Abstract**

According to one embodiment, there is provided a light emitting device (1) includes a substrate (2); a first light emitting element (3a) mounted on one surface side of the substrate (2); a second light emitting element (3b) mounted on the one surface side of the substrate and having a light emitting layer (19) positioned above a light emitting layer (12) of the first light emitting element (3a); and a fluorescent material layer (5) covering the first light emitting element (3a) and containing a fluorescent material (16).

## Description

### FIELD

Embodiments described herein relate generally to a light emitting element and an illumination apparatus on which the light emitting device is disposed.

### BACKGROUND

A chip on board (COB) type light emitting device is used in the illumination apparatus. The COB type light emitting device has a structure in which, for example, a plurality of blue light emitting elements are provided in lines on one surface of a metal base substrate having a resin layer on the surface side thereof and a frame section surrounding the light emitting elements is provided. A sealing resin containing a fluorescent material such as a silicone resin in which a yellow fluorescent material is mixed is filled inside the frame body and each of the light emitting elements is embedded in the sealing resin. Furthermore, a red light emitting element is mixed in addition to the blue light emitting element and then the light emitting elements may be covered by the same translucent resin for the purpose of improved color rendering.

### BRIEF DESCRIPTION OF THE DRAWINGS

FIG. 1 is a schematic top view illustrating a light emitting device according to a first embodiment.
FIG. 2 is a schematic cross-sectional view illustrating the light emitting device which is taken along an arrow direction A-A in FIG. 1.
FIG. 3A is a partial schematic cross-sectional view illustrating the light emitting device which is taken along an arrow direction B-B in FIG. 1, and FIG. 3B is a schematic diagram illustrating light distribution characteristics of the first light emitting element and the second light emitting element.
FIG. 4 is a partial cross-sectional view illustrating a light emitting device of a modification example of the first embodiment.
FIG. 5 is a conceptual cross-sectional view illustrating a light emitting device of a second modification example of the first embodiment.
FIG. 6 is a partial cross-sectional view illustrating the light emitting device of the second modification example.
FIG. 7 is a partial cross-sectional view illustrating a third modification example of the first embodiment.
FIG. 8 is a schematic side view with a portion of the illumination apparatus according to a second embodiment being cutaway.

### DETAILED DESCRIPTION

In general, according to an embodiment, a light emitting device is provided which includes a substrate; a first light emitting element mounted on one surface side of the substrate; a second light emitting element mounted on the one surface side of the substrate and having a light emitting layer positioned above a light emitting layer of the first light emitting element; and a fluorescent material layer covering the first light emitting element and containing a fluorescent material.

Hereinafter, exemplary embodiments will be described with reference to the drawings. First, a first embodiment is described.

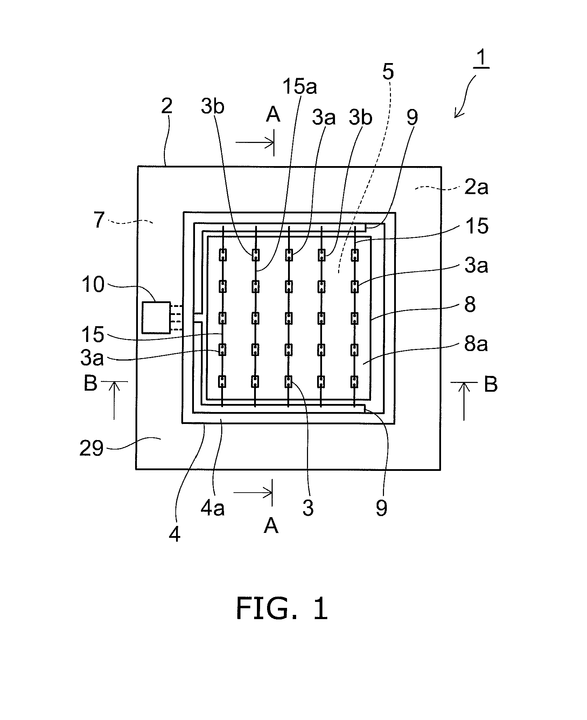

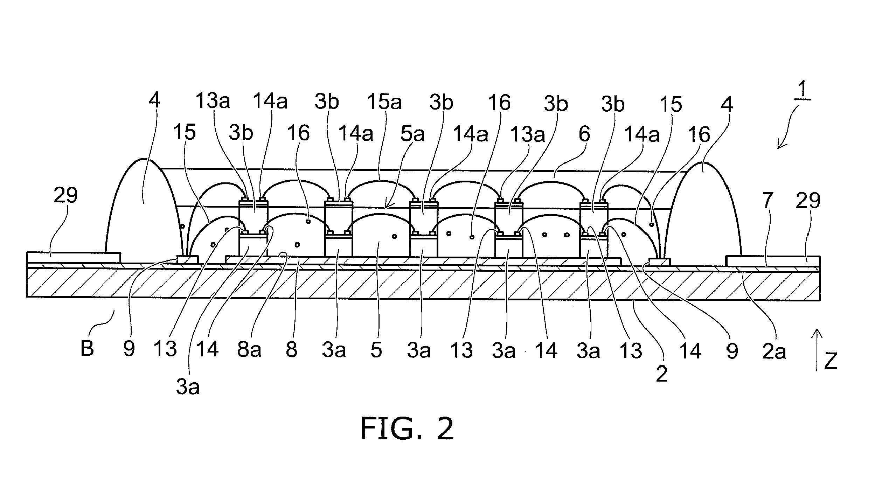

A light emitting device 1 of the embodiment is configured as illustrated in FIGS. 1 and 2. As illustrated in FIG. 2, the light emitting device 1 has a substrate 2, a first light emitting element 3a, a second light emitting element 3b, a frame section 4, a fluorescent material layer 5 and a translucent resin 6.

The substrate 2 is formed, for example, from aluminum (Al) which has a square flat shape having a thickness of 1 mm. In addition, an insulation layer 7, for example, having a thickness of 80 µm is formed on one surface 2a thereof. The insulation layer 7 is formed from, for example, an epoxy material and an inorganic filler material, and has high thermal conductivity. A metal plating section 8, for example, having a thickness of 10 µm is provided on a surface of the insulation layer 7. The metal plating section 8 is formed by metal plating. The metal plating section 8 is formed from a conductive material of, for example, copper (Cu), copper (Cu) on which nickel (Ni) is plated and then silver (Ag) is further plated thereon.

As illustrated in FIG. 1, the metal plating section 8 is formed in a rectangular shape. A pair of wiring patterns 9 and 9 is formed on both end sides of the metal plating section 8. The wiring patterns 9 and 9 are formed on the surface of the insulation layer 7 similar to the metal plating section 8. The wiring patterns 9 and 9 are formed from, for example, a metal layer having a thickness of 10 µm, for example, from a conductive material of copper, or copper on which nickel is plated and then silver is further plated thereon. The wiring patterns 9 and 9 are electrically connected to a female connector 10 provided on one end side of the substrate 2. The female connector 10 is connected to a power supply device supplying a power to the first light emitting element 3a and the second light emitting element 3b.

The first light emitting element 3a and the second light emitting element 3b are mounted on the one surface 2a side of the substrate 2 on which the metal is plated. A plurality of the first light emitting elements 3a and the second light emitting elements 3b are formed and are mounted on a surface 8a side of the metal plating section 8 so that sets of each element are formed alternately. In the specific example illustrated in FIG. 2, an upper surface of the second light emitting element 3b is positioned higher than an upper surface of the first light emitting element 3a in a vertical direction (in the Z direction in FIG. 2) with respect to the one surface (a main surface) 2a of the substrate. In other words, the height of the first light emitting element 3a is lower than the height of the second light emitting element 3b.

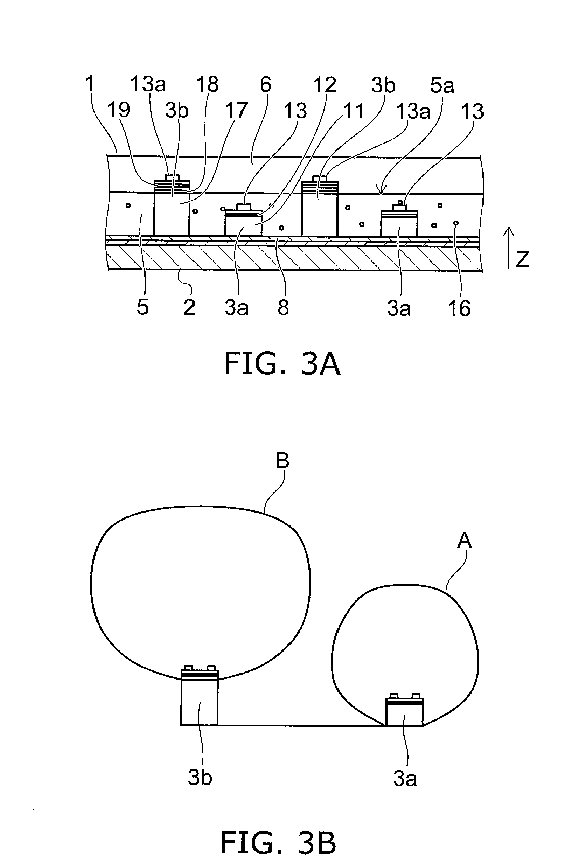

FIG. 3A is a partial schematic cross-sectional view illustrating the light emitting device 1 which is taken along an arrow direction B-B in FIG. 1. FIG. 3B is a schematic diagram illustrating light distribution characteristics of the first light emitting element 3a and the second light emitting element 3b.

As illustrated in FIG. 3A, the first light emitting element 3a has a structure in which a light emitting layer (a first light emitting layer) 12 is formed on a surface of a sapphire 11 which is formed in a rectangular parallelepiped and electrodes 13 and 14 are provided on the surface of the light emitting layer 12. The sapphire 11 is translucent and is bonded to a surface of a silver plating layer of the metal plating section 8 using transparent silicone (not illustrated). The light emitting layer 12 is formed to have, for example, a light emitting material emitting the light in a region of from ultraviolet light to blue light, for example, InGaN and emits a blue light or an ultraviolet light by flowing of an electric current.

In the specification, "the blue light" means a light in which a peak wavelength of the intensity thereof is in a range of 400 to 500 nm. In the specification, "the ultraviolet light" means a light in which a peak wavelength of the intensity thereof is shorter than 400 nm. As illustrated in FIG. 3B, the light distribution A of the first light emitting element 3a has characteristics that the light is spread from the whole element including the sapphire 11.

As illustrated in FIG. 3A, the second light emitting element 3b has a structure in which a metal reflecting layer 18 is formed on a support substrate 17 which is formed in a almost rectangular parallelepiped and hardly transmits the light, and a light emitting layer (a second light emitting layer) 19 is formed on the surface side thereof. The light emitting layer 19 of the second light emitting element 3b is positioned higher than the light emitting layer 12 of the first light emitting element 3a on the one surface 2a of the substrate 2. Electrodes 13a and 14a are provided on the surface of the light emitting layer 19. For example, the support substrate 17 is mainly formed of silicon and has a low transmittance of the light. The metal reflecting layer 18 reflects the light coming from the light emitting layer 19 towards the support substrate 17 side. As a material of the metal reflecting layer 18, a metal having a reflectivity of 80% or more for the emission wavelength is preferably used. Specifically, for example, the metal reflecting layer 18 may be formed of a material made of Au, Ag, Al or alloys thereof. The light emitting layer 19 is formed of, for example, AlGaInP and emits the red light by flowing of an electric current.

In the specification, "the red light" means a light in which a peak wavelength of the intensity thereof is in a range of 590 to 750 nm.

As illustrated in FIG. 3B, light distribution B of the second light emitting element 3b has characteristics that an irradiation amount of the light is relatively large from the upper surface side that is opposite to the substrate 2 side. In other words, the second light emitting element 3b has light distribution characteristics that emission of the light is low from the support substrate 17 or the like that is below the metal reflecting layer 18.

As illustrated in FIGS. 1 and 2, electrode 13 and 14, 13a and 14a of the line-shaped first and second light emitting elements 3a and 3b are wire bonded, respectively. The electrodes 13 and 13a of one end of the line-shaped first light emitting element 3a and the second light emitting element 3b are wire bonded on one side of a pair of wiring patterns 9 and 9; and the electrodes 14 and 14a of the other end of the line-shaped first light emitting element 3a and the second light emitting element 3b are wire bonded on the other side of a pair of wiring patterns 9 and 9. In other words, a plurality of the first and second light emitting elements 3a and 3b are connected in series each other for each line by boding wires 15 and 15a, and are electrically connected to a pair of wiring patterns 9 and 9.

The frame section 4 is formed on the insulation layer 7 of the substrate 2 to surround the first light emitting elements 3a and second light emitting elements 3b. The frame section 4 is formed of a heat curable resin having an insulating property, for example, of a silicone resin. White powder is mixed in the resin material. As the white powder, white filler such as titanium dioxide (TiO2), aluminum oxide (Al2O3), silicon dioxide (Si02), magnesium oxide (MgO), barium oxide (BaO), or the like may be used. The surface thereof serves as a light reflecting surface having a high reflectivity for the visible light by mixing of the white powder.

The fluorescent material layer 5 illustrated in FIGS. 2, 3A and 3B is formed of, for example, the translucent silicone resin and is filled inside the frame section 4, and seals the first light emitting elements 3a. In other words, the first light emitting element 3a and the boding wire 15 are sealed by the fluorescent material layer 5. That is, the light emitting layer 12 of the first light emitting element 3a is positioned below the surface of the fluorescent material layer 5.

The lower portion of the second light emitting element 3b is sealed by the fluorescent material layer 5. However, the light emitting layer 19 of the second light emitting element 3b is not sealed by the fluorescent material layer 5 and is protruded from the fluorescent material layer 5. Specifically, the light emitting layer 19 of the second light emitting element 3b is positioned above the surface of the fluorescent material layer 5.

The surface 5a of the fluorescent material layer 5 is flat. The fluorescent material layer 5 contains a predetermined concentration of a YAG fluorescent material 16 as a fluorescent material. When the blue light emitted from the first light emitting element 3a is incident, the YAG fluorescent material 16 converts the wavelength of the blue light into a wavelength of a yellow light. In other words, the YAG fluorescent material 16 converts the wavelength of a portion of the light emitted from the first light emitting element 3a. The light is emitted from the surface of the fluorescent material layer 5 to the outside obtained by mixing the yellow light of which the wavelength is converted and the blue light emitted from the first light emitting element 3a.

When the ultraviolet light is emitted from the first light emitting element 3a, for example, a fluorescent material which receives the ultraviolet light and emits the blue light, and another fluorescent material which receives the ultraviolet light and emits the yellow light may be contained in the fluorescent material layer 5. Otherwise, the fluorescent material which receives the ultraviolet light emitted from the first light emitting element 3a and emits the blue light, and the fluorescent material which receives the ultraviolet light emitted from the first light emitting element 3a and emits a green light may be contained in the fluorescent material layer 5.

The translucent resin 6 illustrated in FIGS. 2 and 3A and 3B is formed of, for example, translucent silicone resin and is filled inside the frame section 4 and then seals the upper portion including the light emitting layer 19 of the second light emitting elements 3b. In other words, the translucent resin 6 is laminated on the fluorescent material layer 5. In addition, the upper portion of the second light emitting element 3b and boding wire 15a are sealed by the translucent resin 6.

The fluorescent material layer 5 is provided to position on the substrate 2 side from the metal reflecting layer 18 and the light emitting layer 19 of the second light emitting element 3b (in other words, the metal reflecting layer 18 and the light emitting layer 19 is above the surface of the fluorescent material layer 5). Accordingly, the translucent resin 6 is formed to emit mainly the light transmitted from the fluorescent material layer 5 and the red light irradiated from the second light emitting element 3b.

As illustrated in FIGS. 1 and 2, a white resist 29 is applied on the insulation layer 7 of the substrate 2 outside the frame section 4.

Next, operation of the first embodiment will be described.

The light emitting device 1 is configured such that when the power is supplied from the power supply device to the female connector 10, a predetermined current flows in the first light emitting element 3a and the second light emitting element 3b. In the first light emitting element 3a, the blue light is emitted from the light emitting layer 12 by flowing of the electric current. The emitted blue light transmits the sapphire 11 side or is directly emitted to the upper surface side and then the light distribution A (see, FIG. 3B) in which the light is spread from the whole element is formed. A portion of the blue light transmits the fluorescent material layer 5 and emits to outside. The wavelength of a portion of the blue light is converted to the yellow light by the YAG fluorescent material 16 contained in the fluorescent material layer 5 and transmits the fluorescent material layer 5 and then emits to the translucent resin 6 side.

A portion of each of the blue light and the yellow light, is incident to and reflected on the metal plating section 8 provided on the one surface 2a side of the substrate 2. A portion of the reflected light which is incident in the fluorescent material layer 5 transmits the fluorescent material layer 5 and emits to outside.

In the second light emitting element 3b, the red light is emitted from the light emitting layer 19 by flowing of the electric current. The emitted red light is directly emitted to the upper surface side and is reflected to the upper surface side on the metal reflecting layer 18. Thus, in the light distribution B (see, FIG. 3B) on the second light emitting element 3b, the irradiation amount of the light from the upper side is relatively large. Since both of the light emitting layer 19 and the metal reflecting layer 18 of the second light emitting element 3b are provided at a position above the fluorescent material layer 5, most of the light emitted from the second light emitting element 3b is not incident on the fluorescent material layer 5. Thus, it can be suppressed that the red light is reflected multiply in the fluorescent material layer 5 and extraction efficiency of the red light can be improved. Specifically, in the embodiment, the metal reflecting layer 18 as well as the light emitting layer 19 is positioned above the fluorescent material layer 5 so that the operation and effect thereof are further enhanced.

Since a portion of the blue light, the yellow light and the red light, respectively is emitted within the frame section 4, a portion thereof transmits the translucent resin 6 and is emitted to outside.

The white light having a desired color temperature is obtained by mixing the blue light and the yellow light emitted from the fluorescent material layer 5, and the red light of the second light emitting element 3b in the translucent resin 6. In other words, the white light is emitted from the light emitting device 1.

According to the embodiment, combination of the first light emitting element 3a and the fluorescent material layer 5, and combination of the second light emitting element 3b and the translucent resin 6 can be formed without being separated by a separated structure. In other words, as another configuration enhancing the extraction efficiency of the red light, a configuration may be adapted in which after the fluorescent material layer 5 is applied with respect to the first light emitting element 3a and one light emitting region is formed, the translucent resin 6 is applied with respect to the second light emitting element 3b for the purpose of protection of the element or the wire and then another light emitting region is formed. However, since steps of production or members are increased when the configuration described above is adapted, the productivity is lowered. However, in the embodiment, since a series of application steps can be carried out without the need for a member to define specifically each of the light emitting regions, the possibility that the productivity is lowered can be suppressed.

In the specific example illustrated in FIGS. 1 to 3A and 3B, the configuration of each of the light emitting elements 3a and 3b is a so-called upper electrode type; however, the embodiment may use a light emitting element of an upper-lower electrode type or a backside electrode type. Even though any type of the light emitting element is used, the light emitted from the light emitting element that is the light emitting color, which does not use mainly the excitation of the fluorescent material may be extracted without the fluorescent material layer. In order to achieve the position of the second light emitting element 3b which does not use mainly the excitation of the fluorescent material and the fluorescent material layer 5, as the embodiment, the substrate structure on which the second light emitting element 3b is mounted may be devised. For example, the structure is configured such that a convex section is formed on the mounting side of the substrate 2, the second light emitting element 3b is mounted on the convex section and much emission light from the second light emitting element 3b is not incident to the fluorescent material layer 5.

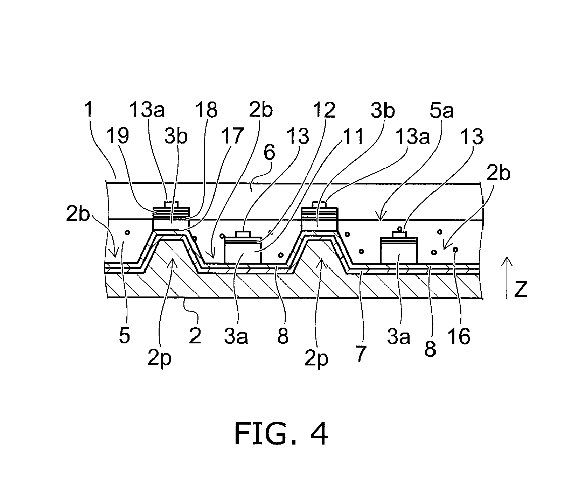

FIG. 4 is a partial cross-sectional view illustrating a modification example. In other words, FIG. 4 is a partial cross-sectional view of the modification example which is taken along an arrow direction B-B in FIG. 1 similar to FIG. 3A.

In the modification example, the one surface 2a of the substrate 2 has a bottom section 2b and a convex section 2p protruding from the bottom section 2b. The insulation layer 7 and the metal plating section 8 are laminated along a surface of the convex section 2p. The first light emitting element 3a is mounted on the bottom section 2b. The second light emitting element 3b is mounted on the convex section 2p.

As described above, the heights of the light emitting layer 12 of the first light emitting element 3a and the light emitting layer 19 of the second light emitting element 3b can be adjusted also by providing a height difference or a step on the one surface 2a of the substrate 2. Specifically, the light emitting layer 19 may be positioned above the light emitting layer 12. As a result, the same effect as the above description with respect to FIGS. 1 to 3A and 3B may be obtained.

In the modification example, the height of the first light emitting element 3a and the height of the second light emitting element 3b may be selected freely. For example, the second light emitting element 3b having the height lower than the height of the first light emitting element 3a may be used by adjusting the height of the convex section 2p. In other words, the degree of freedom of selection of the light emitting elements 3a and 3b is increased.

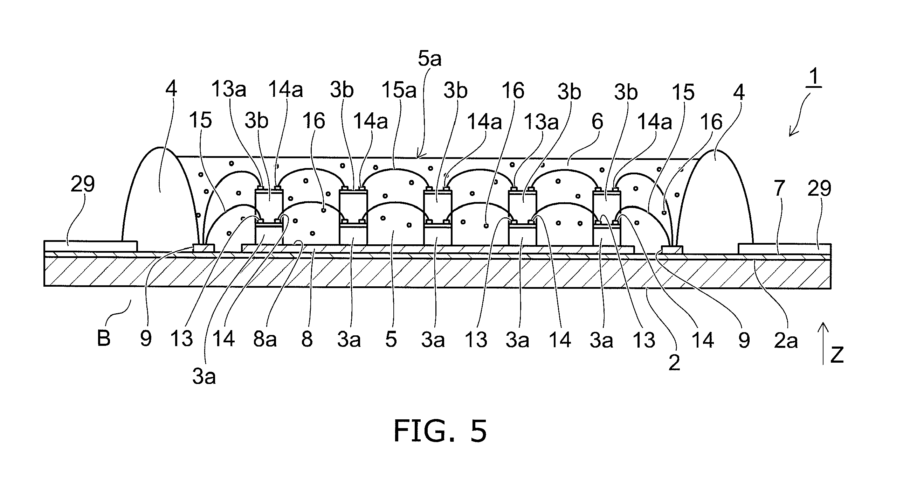

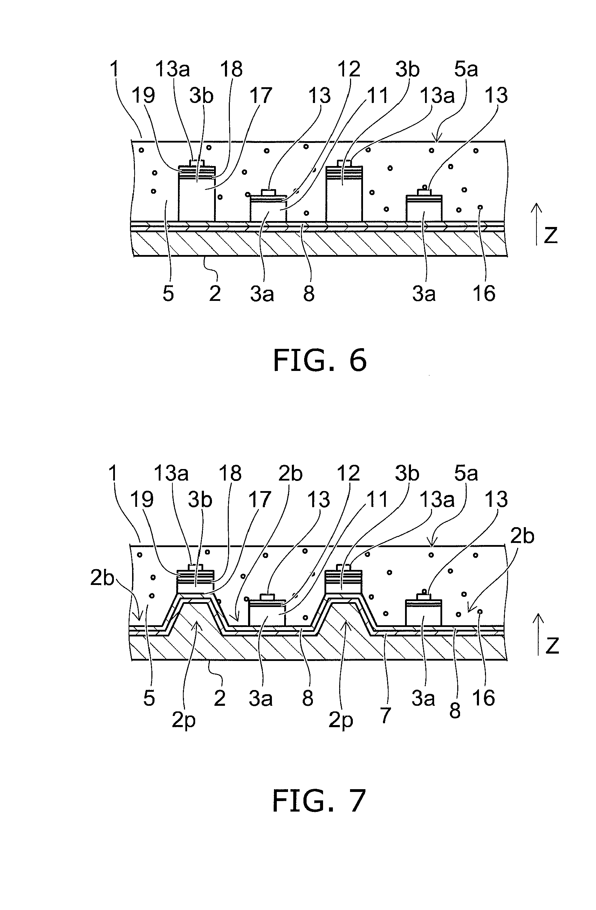

FIGS. 5 and 6 are schematic diagrams illustrating a second modification example of the embodiment.

FIG. 5 corresponds to a schematic cross-sectional view which is taken along the arrow direction A-A in FIG. 1.

FIG. 6 corresponds to a schematic cross-sectional view which is taken along the arrow direction B-B in FIG. 1.

Also in the modification example, the light emitting layer 19 of the second light emitting element 3b is positioned above the light emitting layer 12 of the first light emitting element 3a on the one surface 2a of the substrate 2.

However, in the modification example, the second light emitting element 3b, as well as the first light emitting element 3a is also covered by the fluorescent material layer 5. In other words, the light emitting layer 19 of the second light emitting element 3b is positioned below the surface 5a of the fluorescent material layer 5. A distance from the light emitting layer 19 of the second light emitting element 3b to the surface 5a of the fluorescent material layer 5 is shorter than a distance from the light emitting layer 12 of the first light emitting element 3a to the surface 5a of the fluorescent material layer 5.

In the modification example, the light emitted from the second light emitting element 3b also passes through the fluorescent material layer 5 and is extracted to outside. Accordingly, for example, when the second light emitting element 3b emits the red light, the red light passes through the fluorescent material layer 5 and is emitted to outside. However, the light emitting layer 19 of the second light emitting element 3b is positioned above the light emitting layer 12 of the first light emitting element 3a. Accordingly, an optical path length in the fluorescent material layer 5 through which the light emitted from the second light emitting element 3b passes before the extraction of the light to outside is shorter than that of the first light emitting element 3a. Absorption and scattering of the light inside the fluorescent material layer 5 can be reduced by shortening the optical path length.

As a result, the loss of the light emitted from the second light emitting element 3b by absorbing or scattering the light inside the fluorescent material layer 5 can be reduced while the wavelength of the light emitted from the first light emitting element 3a is sufficiently converted in the fluorescent material layer 5.

FIG. 7 is a schematic diagram illustrating a third modification example of the embodiment.

In other words, FIG. 7 corresponds to a schematic cross-sectional view which is taken along the arrow direction B-B in FIG. 1.

The modification example combines the first modification example illustrated in FIG. 4 and the second modification example illustrated in FIGS. 5 and 6.

As illustrated in FIG. 7, the one surface 2a of the substrate 2 has the bottom section 2b and the convex section 2p protruding from the bottom section 2b. The light emitting layer 19 of the second light emitting element 3b mounted on the convex section 2p is positioned above the light emitting layer 12 of the first light emitting element 3a mounted on the bottom section 2b. The light emitting layer 19 of the second light emitting element 3b is positioned below the surface 5a of the fluorescent material layer 5.

According to the third modification example, the same effect as the above description with respect to the first modification example and the second modification example may be obtained.

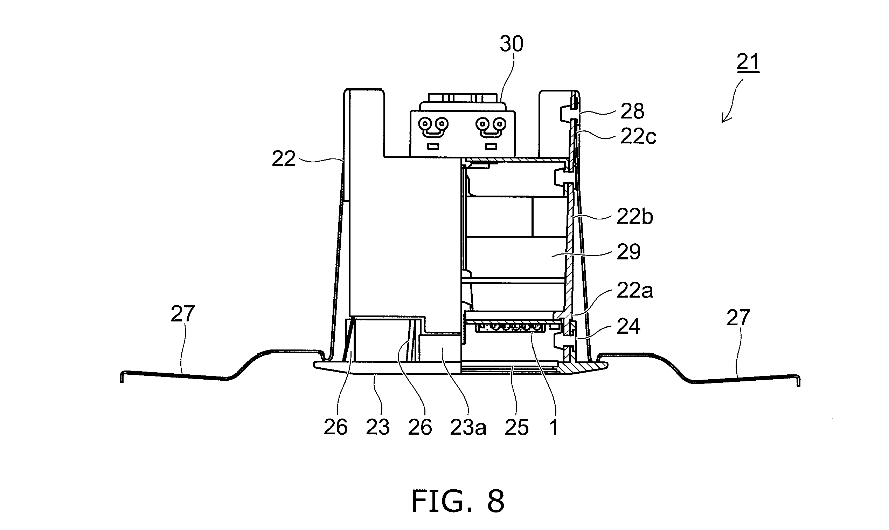

Next, a second embodiment will be described. An illumination apparatus 21 of the embodiment is configured as illustrated in FIG. 8. In FIG. 8, the same reference numeral will be given to the same configuration in FIGS. 1 to 7 and the description thereof will be omitted.

The illumination apparatus 21 is a down-light embedded in a ceiling surface or the like. A circular decorative frame 23 is attached to a lower end side 22a of a substantially cylindrical apparatus body 22 by using a rivet 24 and a translucent cover 25 is disposed on the decorative frame 23. The decorative frame 23 has a reinforcement piece 26 on an outer surface 23a thereof.

A pair of mounting springs 27 and 27 for fixing the apparatus body 22 to the ceiling surface or the like on both the left and right sides is mounted on the apparatus body 22 by using a rivet 28. Four light emitting devices 1 illustrated in FIGS. 1 to 7 are disposed inside the lower end side 22a of the apparatus body 22 in a rotationally symmetrical manner.

A power supply device 29 is disposed inside an intermediate side 22b of the apparatus body 22. The power supply device 29 is formed so as to convert AC power to DC power and to supply constant current (power supply) to the first light emitting element 3a of the light emitting device 1. A terminal stand 30 which connects a power supply line (not illustrated) from an AC power supply is disposed on an upper surface side 22c of the apparatus body 22.

The illumination apparatus 21 of the embodiment has the effect that the extraction efficiency of the light can be increased.

In FIG. 8, as the illumination apparatus 21, the embedded type down-light is exemplified; however, the embodiment is not limited to the configuration. Besides the down-light type, for example, an illumination apparatus including the light emitting device 1, such as an elongated embedded type, a direct mounting type, a pendant type or the like, or a lamp apparatus such as a LED light bulb or the like is included in the range of the invention.

While certain embodiments have been described, these embodiments have been presented by way of example only, and are not intended to limit the scope of the inventions. Indeed, the novel embodiments described herein may be embodied in a variety of other forms; furthermore, various omissions, substitutions and changes in the form of the embodiments described herein may be made without departing from the spirit of the inventions. The accompanying claims and their equivalents are intended to cover such forms or modifications as would fall within the scope and spirit of the inventions.

## Claims

1. A light emitting device (1) comprising:
a substrate (2);
a first light emitting element (3a) mounted on one surface side of the substrate;
a second light emitting element (3b) mounted on the one surface side of the substrate and comprising a light emitting layer (19) positioned above a light emitting layer (12) of the first light emitting element; and
a fluorescent material layer (5) covering the first light emitting element and containing a fluorescent material (16).

2. The device according to claim 1,
wherein the second light emitting element (3b) is mounted on the one surface side of the substrate (2) so that the light emitting layer (19) is positioned above the fluorescent material layer (5).

3. The device according to claim 2,
wherein the second light emitting element (3b)includes a reflecting layer (18) below the light emitting layer (19), and
wherein the second light emitting element is mounted on the one surface side of the substrate (2) so that the reflecting layer (18) is positioned above the fluorescent material layer (5).

4. The device according to any one of claims 1 to 3 further comprising:
a translucent resin (6) which is provided to cover the fluorescent material layer (5) and the second light emitting element (3b).

5. The device according to claim 1,
wherein the second light emitting element is mounted on the one surface side of the substrate (2) so that the light emitting layer (19) is positioned below the surface of the fluorescent material layer (5).

6. The device according to any one of claims 1 to 5, wherein a height of the first light emitting element (3a) from the one surface of the substrate (2) is lower than a height of the second light emitting element (3b) from the one surface of the substrate (2).

7. The device according to any one of claims 1 to 5,
wherein the one surface of the substrate (2) includes a bottom section (2b) and a convex section (2p) protruding from the bottom section,
wherein the first light emitting element (3a) is mounted on the bottom section (2b), and
wherein the second light emitting element (3b) is mounted on the convex section (2p).

8. The device according to any one of claims 1 to 7, wherein a rate of an emission amount of the light emitted from an upper surface side that is the opposite side to the substrate side in the light emitted from the second light emitting element (3b) is greater than a rate of an emission amount of the light emitted from an upper surface side that is the opposite side to the substrate side in the light emitted from the first light emitting element (3a).

9. The device according to any one of claims 1 to 8, wherein a peak wavelength of intensity of the light emitted from the first light emitting element (3a) is shorter than a peak wavelength of the intensity of the light emitted from the second light emitting element (3b).

10. The device according to any one of claims 1 to 9, wherein the first light emitting element (3a) emits a blue light.

11. The device according to any one of claims 1 to 10, wherein the second light emitting element (3b) emits a red light.

12. An illumination apparatus comprising:
the light emitting device according to any one of claims 1 to 11; and
a lighting device supplying a power to the light emitting device.
